# EUROPÄISCHE PATENTANMELDUNG

(11) **EP 0 792 025 A1**
(43) Veröffentlichungstag der Anmeldung: **27.08.1997**
(21) Anmeldenummer: 96118174.0
(22) Anmeldetag: 13.11.1996
(51) Int. Cl.: H04B 1/38, H05K 5/02, H01R 13/24

(54) **Gehäuse zur Unterbringung eines elektrischen Gerätes mit vom Gehäuseäusseren zugänglichen elektrischen Kontakten**

(30) Priorität: 20.02.1996 DE 19606187
(71) Anmelder: ROBERT BOSCH GMBH, 70442 Stuttgart (DE)
(72) Erfinder: Heidrich, Michael, 12043 Berlin (DE); Birkl, Gerard-Emile, 12051 Berlin (DE); Siebeneicher, Wolfgang, 12203 Berlin (DE); Herrmann, Volker, 10437 Berlin (DE)

(57) **Zusammenfassung**

Es wird ein Gehäuse (3) vorgeschlagen, das zur Unterbringung eines elektrischen Gerätes, insbesondere eines Handfunkgerätes, dient. Das Gehäuse umfaßt vom Gehäuseäußeren zugängliche elektrische Kontakte (14). Es weist einen ersten Träger (1) aus elektrisch isolierendem Material auf, das die Kontakte (14) vorzugsweise mittels Spritzguß gas- und wasserdicht umschließt. Die Kontakte (14) sind über Durchbrüche (19) im ersten Träger (1) von außen zugänglich. Der erste Träger (1) ist in das Gehäuse (3) eingelegt und vorzugsweise mittels Spritzguß gas- und wasserdicht mit dem Gehäuse (3) verbunden. Die Kontakte (14) sind über Kontaktbahnen (35) elektrisch leitend mit im Inneren des Gehäuses (3) untergebrachten elektronischen Bauteilen verbunden. Der erste Träger (1) weist eine erste und eine zweite von außen zugängliche Öffnung (12, 13) auf. Die erste und die zweite Öffnung (12, 13) haben unterschiedliche Form. Auf diese Weise läßt sich eine gas- und wasserdichte Kontaktierung zwischen Steckkontakten (17) eines Gerätesteckers und den Kontakten (14) erzielen, wobei der Gerätestecker verpolungssicher über die beiden Öffnungen (12, 13) am Gehäuse (3) befestigt werden kann.

## Beschreibung

### Stand der Technik

Die Erfindung geht von einem Gehäuse zur Unterbringung eines elektrischen Gerätes nach der Gattung des Hauptanspruchs aus.

Es sind schon Gehäuse zur Unterbringung elektrischer Geräte bekannt, bei denen elektrische Kontakte vom Gehäuseäußeren zugänglich sind. Soll diese Außenkontaktierung vor Wasser und Gas geschützt werden, so erfolgte dies bisher mittels Dichtungen, mit denen die Außenkontakte mechanisch im Gerät befestigt werden.

### Vorteile der Erfindung

Das erfindungsgemäße Gehäuse mit den Merkmalen des Hauptanspruchs hat demgegenüber den Vorteil, daß keine zusätzlichen Dichtungsteile zum Schutz der Außenkontakte vor Wasser- und Gaseinflüssen erforderlich sind, da die Kontakte vorzugsweise mittels Spritzguß gas- und wasserdicht von einem elektrisch isolierenden Trägermaterial umschlossen sind.

Vorteilhaft ist auch, daß das Trägermaterial in das Gehäuse eingelegt und vorzugsweise mittels Spritzguß gas- und wasserdicht mit dem Gehäuse verbunden ist. Auf diese Weise werden zwischen dem Trägermaterial und dem Gehäuse ebenfalls keine zusätzlichen Dichtungsteile, genausowenig wie zusätzliche Befestigungselemente, benötigt.

Durch die in den Unteransprüchen aufgeführten Maßnahmen sind vorteilhafte Weiterbildungen und Verbesserungen des im Hauptanspruch angegebenen Gehäuses möglich.

Besonders vorteilhaft gemäß Anspruch 3 ist die Anbringung weiterer Träger an den Kontaktbahnen und die Biegung der Kontaktbahnen so, daß der erste und der zweite Träger einander gegenüberliegen. Auf diese Weise ist eine extrem platzsparende Unterbringung der Außenkontakte im Gehäuse möglich, wobei die Innenkontaktierung mit im Inneren des Gehäuses untergebrachten elektronischen Bauteilen in unmittelbarer Nähe der Außenkontaktierung stattfinden kann.

Vorteilhaft gemäß Anspruch 5 ist die erste und die zweite von außen zugängliche Öffnung des ersten Trägers, wobei die erste und die zweite Öffnung unterschiedliche Form haben. Auf diese Weise kann eine Kontaktierung zwischen den Kontakten und einem von außen herangeführten Gerätestecker verpolungssicher durchgeführt werden, wenn der Gerätestecker mit der Form der Öffnungen korrespondierende Steckbolzen aufweist, die bei der Kontaktierung in die Öffnungen greifen. Über die beiden Öffnungen ist auch eine stabile Befestigung des von außen herangeführten Gerätesteckers am Gehäuse möglich.

Vorteilhaft gemäß Anspruch 6 ist das Drücken der Kontaktbahnen im Inneren des Gehäuses direkt gegen einen auf ein elastisches Material aufgebrachten Gegenkontakt, der gleichzeitig mit Kontakten mindestens einer Leiterplatte elektrisch leitend verbunden ist. Auf diese Weise ist eine einfache Innenkontaktierung möglich, die keine Befestigungsmittel zwischen den Kontaktbahnen und dem Gegenkontakt erfordert, so daß auch eine einfache Demontage möglich ist.

Vorteilhaft gemäß Anspruch 7 ist die Unterbringung der aus dem ersten Träger herausragenden Kontaktbahnen an dem Ende, das mit den Kontakten versehen ist, in einem Spalt des Gehäuses. Auf diese Weise wird die Verbindung zwischen dem ersten Träger und dem Gehäuse zusätzlich stabilisiert.

Eine vorteilhafte zusätzliche Stabilisierung der Kontakte im Gehäuse erfolgt gemäß Anspruch 9 auch durch die Wulst des dritten Trägers, die in einer Nut des Gehäuses rastet, und gemäß Anspruch 10 durch Vorsprünge des ersten Trägers, die in entsprechende Einbuchtungen des Gehäuses greifen.

### Zeichnung

Ein Ausführungsbeispiel der Erfindung ist in der Zeichnung dargestellt und in der nachfolgenden Beschreibung näher erläutert. Es zeigen Figur 1 einen Querschnitt durch das Gehäuse, Figur 2 von drei Trägern umschlossene Kontaktbahnen im ungebogenen Zustand, Figur 3 einen Querschnitt durch Kontaktbahn und Träger im gebogenen Zustand der Kontaktbahnen und Figur 4 eine Außenansicht eines im Gehäuse integrierten Trägers mit den Außenkontakten.

### Beschreibung des Ausführungsbeispiels

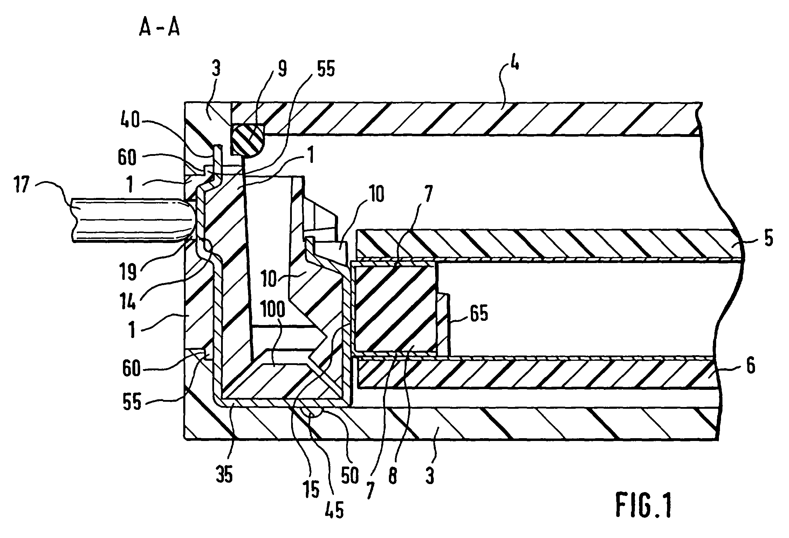

In Figur 1 kennzeichnet 3 ein Gehäuse zur Unterbringung eines als Handfunkgerät ausgebildeten elektrischen Gerätes.

Dabei kann es sich jedoch auch um jedes andere beliebige elektrische Gerät handeln, wie beispielsweise um Rasierapparate, Kofferradios, Fotoapparate, usw. Das Gehäuse 3 weist einen ersten Träger 1 aus elektrisch isolierendem Material auf, der einen elektrischen Kontakt 14 gas- und wasserdicht umschließt. Der Kontakt 14 ist über einen Durchbruch 19 im ersten Träger 1 von außen zugänglich. Der erste Träger 1 weist an seiner dem Gehäuseäußeren zugewandten Seite zwei Vorsprünge 55 auf, die in entsprechende Einbuchtungen 60 des Gehäuses 3 greifen. Auf diese Weise ist der erste Träger 1 in das Gehäuse 3 eingelegt. Die Verbindung des ersten Trägers 1 mit dem Gehäuse 3 ist gas- und wasserdicht und erfolgt durch Umspritzen oder Umgießen des ersten Trägers 1 mit Gehäusematerial, vorzugsweise wird ein Spritzgußverfahren angewandt. Die Umschließung des Kontaktes 14 mit dem ersten Träger 1 soll ebenfalls gas- und wasserdicht sein, so daß sie ebenfalls durch Umspritzen oder Umgießen, vorzugsweise ebenfalls durch ein Spritzgußverfahren, erfolgt. Der Kontakt 14 ist über eine Kontaktbahn 35 elektrisch leitend mit im Inneren des Gehäuses 3 untergebrachten elektronischen Bauteilen verbunden. Der Kontakt 14 ist als Teil der Kontaktbahn 35 gegenüber der Kontaktbahn 35 zum Gehäuseäußeren hin gebogen. Auf diese Weise ist für die Kontaktierung des Kontaktes 14 mit einem Steckkontakt 17 eines von außen herangeführten Gerätesteckers über den Durchbruch 19 nur ein geringer Kontaktweg erforderlich, so daß eine Kontaktierung auch durch einen Steckkontakt 17, dessen Durchemsser größer als der Durchmesser des Durchbruchs 19 ist, ermöglicht wird, wenn der Steckkontakt 17 an seinem Ende abgerundet ist. Dadurch, daß der Kontakt 14 Teil der Kontaktbahn 35 ist, wird auch die Kontaktbahn 35 teilweise vom ersten Träger 1 umschlossen. An dem Ende der Kontaktbahn 35, das mit dem Kontakt 14 versehen ist, ragt die Kontaktbahn 35 aus dem ersten Träger 1 heraus und ist in einem Spalt 40 des Gehäuses 3 wasser- und gasdicht vom Gehäuse 3 umschlossen. Auch diese Umschließung erfolgt mittels Umspritzen oder Umgießen, vorzugsweise ebenfalls durch ein Spritzgußverfahren. Auf diese Weise ist der erste Träger 1 mit dem Kontakt 14 besonders stabil im Gehäuse 3 gelagert. An dem Ende der Kontktbahn 35, das nicht mit dem Kontakt 14 versehen ist, befindet sich ein zweiter Träger 10 und zwischen dem ersten und dem zweiten Träger 1 und 10 befindet sich ein dritter Träger 100. Der zweite und der dritte Träger umschließen die Kontaktbahn 35 ebenfalls. Zwischen den einzelnen Trägern 1, 10 und 100 ist die Kontaktbahn 35 so gebogen, daß der erste und der zweite Träger 1 und 10 einander gegenüberliegen. Der zweite Träger 10 zeigt somit zum Gehäuseinneren, während der dritte Träger 100 zum Gehäuse 3 gewandt ist. Auf der dem Gehäuse 3 zugewandten Seite der Kontaktbahn 35 weist der dritte Träger 100 eine Wulst 45 auf, die in einer Nut 50 des Gehäuses 3 rastet. Ein mit dem zweiten Träger 10 verbundener Teil der Kontaktbahn 35 druckt im Inneren des Gehäuses 3 direkt gegen einen auf ein elastisches Material 8 aufgebrachten Gegenkontakt 15, der gleichzeitig über rechtwinklig zum Gegenkontakt 15 angebrachte, mit dem Gegenkontakt 15 elektrisch leitend verbundenen und ebenfalls auf das elastische Material 8 aufgebrachten Leiterplattenkontakten 7 mit Kontakten einer ersten und einer zweiten Leiterplatte 5 und 6 elektrisch leitend verbunden ist. Über eine Arretierung 65, die an der zweiten Leiterplatte 6 befestigt ist, wird der Gegenkontakt 15 mit den Leiterplattenkontakten 7 vor Verrutschen gesichert, so daß die Druckkontaktierung zwischen der Kontaktbahn 35 und dem Gegenkontakt 15 stabil ist. Über eine Dichtung 9 ist das Gehäuse 3 mit einem Gerätedeckel 4 gas- und wasserdicht verschlossen.

Durch die beschriebene Anordnung ist eine elektrisch leitende Verbindung zwischen elektronischen Bauelementen auf den beiden Leiterplatten 5 und 6 im Inneren des Gehäuses 3 und dem Steckkontakt 17, der von außen an den Kontakt 14 herangeführt ist, möglich.

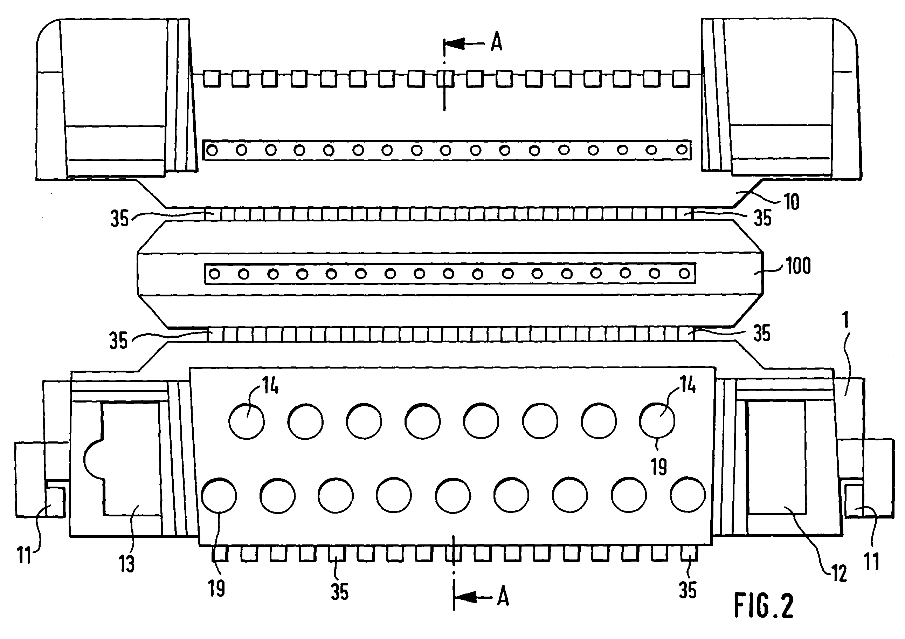

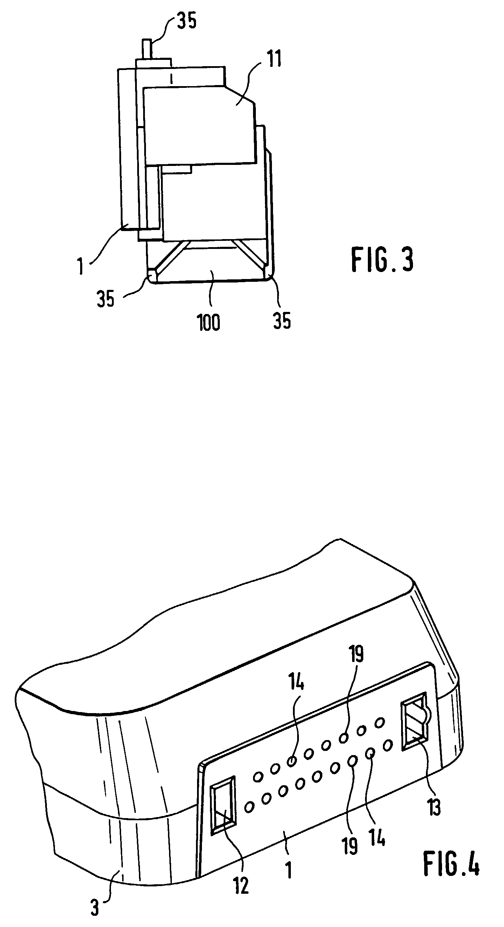

Die Figur 1 stellt einen Querschnitt A-A durch das Gehäuse 3 dar. In Figur 2 sind die drei Träger 1, 10 und 100 in Draufsicht und bei nicht gebogener Kontaktbahn 35 dargestellt. Der in Figur 1 dargestellte Querschnitt A-A ist in Figur 2 ebenfalls gestrichelt eingezeichnet. Dabei wird in Figur 2 deutlich, daß mehrere Kontaktbahnen 35 vorhanden sein können. In Figur 2 sind es 17 Kontaktbahnen 35, zu denen jeweils ein Kontakt 14 gehört. Dabei sind die Kontakte 14 platzsparend in zwei Reihen im ersten Träger 1 untergebracht und jeweils über einen Durchbruch 19 von außen zugänglich. Der erste Träger 1 weist rechts und links von den beiden Kontaktreihen mit den Kontakten 14 eine erste und eine zweite Öffnung 12 und 13 auf, zur Aufnahme entsprechender Steckbolzen des von außen herangeführten Gerätesteckers, der gemäß Figur 1 Steckkontakte 17 zur Kontaktierung mit den Kontakten 14 aufweist. Durch das Eingreifen der nicht dargestellten Steckbolzen des Gerätesteckers in die beiden Öffnungen 12 und 13 wird der Gerätestecker zur Befestigung im ersten Träger 1 aufgenommen. Die beiden Öffnungen 12 und 13 haben eine unterschiedliche Form, die mit entsprechend unterschiedlich geformten Steckbolzen des Gerätesteckers korrespondieren, so daß der Gerätestecker verpolungssicher mit dem ersten Träger 1 verbunden werden kann. Am ersten Träger 1 ist gemäß Figur 2 neben den beiden Öffnungen 12 und 13 jeweils ein Haltehaken 11 angebracht, wobei die Haltehaken 11 bei gemäß Figur 1 beziehungsweise Figur 3 gebogenen Kontaktbahnen 35 den ersten und den zweiten Träger 1 und 10 kraftschlüssig miteinander verbinden, wie in Figur 3 dargestellt ist.

Zwischen den einzelnen Trägern 1, 10 und 100 ist jeweils ein Zwischenraum, der für die beschriebene Biegung der Kontaktbahnen 35 in diesen Zwischenräumen ausreicht.

In Figur 4 ist eine Außenansicht des im Gehäuse 3 integrierten ersten Trägers 1 mit den über die Durchbrüche 19 von außen zugänglichen Kontakten 14 sowie mit den beiden Öffnungen 12 und 13 dargestellt. Ein entsprechender Gerätestecker wird wie beschrieben in den beiden Öffnungen 12 und 13 verpolungssicher befestigt, so daß die Steckkontakte 17 des Gerätesteckers mit den Kontakten 14 kontaktieren. Durch die entsprechende gas- und wasserdichte Umschließung der Kontakte 14 ist die Kontaktierung vor entsprechenden Witterungseinflüssen geschützt.

An einem Kontakt 14 über den entsprechenden Steckkontakt 17 eines Gerätesteckers anstehende Signale oder Ströme von beispielsweise einer als externes Mikrofon ausgebildeten Freisprecheinrichtung, von einem Lautsprecher, von einem Bedienteil, von einer Antenne oder dergleichen werden über die zugehörige Kontaktbahn 35 zum Gegenkontakt 15 weitergeleitet und können mittels den Leiterplattenkontakten 7 auf die erste und die zweite Leiterplatte 5 und 6 verteilt werden. Dies gilt auch in umgekehrter Richtung von der Leiterplatte zu den entsprechenden Kontakten 14.

## Patentansprüche

1. Gehäuse (3) zur Unterbringung eines elektrischen Gerätes, insbesondere eines Handfunkgerätes, mit vom Gehäuseäußeren zugänglichen elektrischen Kontakten (14), dadurch gekennzeichnet, daß das Gehäuse (3) einen ersten Träger (1) aus elektrisch isolierendem Material aufweist, das die Kontakte (14) vorzugsweise mittels Spritzguß gas- und wasserdicht umschließt, daß die Kontakte (14) über Durchbrüche (19) im ersten Träger (1) von außen zugänglich sind und daß der erste Träger (1) in das Gehäuse (3) eingelegt und vorzugsweise mittels Spritzguß gas- und wasserdicht mit dem Gehäuse (3) verbunden ist.

2. Gehäuse (3) nach Anspruch 1, dadurch gekennzeichnet, daß die Kontakte (14) über Kontaktbahnen (35) elektrisch leitend mit im Innern des Gehäuses (3) untergebrachten elektronischen Bauteilen verbunden sind.

3. Gehäuse (3) nach Anspruch 2, dadurch gekennzeichnet, daß an dem Ende der Kontaktbahnen (35), das nicht mit Kontakten (14) versehen ist, ein zweiter Träger (10) und zwischen dem ersten und dem zweiten Träger (1, 10) ein dritter Träger (100) vorgesehen sind, die die Kontaktbahnen (35) umschließen und daß die Kontaktbahnen (35) zwischen den einzelnen Trägern (1, 10, 100) so gebogen sind, daß der erste und der zweite Träger (1, 10) einander gegenüberliegen.

4. Gehäuse (3) nach Anspruch 3, dadurch gekennzeichnet, daß am ersten und /oder zweiten Träger (1, 10) mindestens ein Haltehaken (11) vorgesehen ist, durch den der erste und der zweite Träger (1, 10) kraftschlüssig miteinander verbindbar sind.

5. Gehäuse (3) nach einem der vorherigen Ansprüche, dadurch gekennzeichnet, daß der erste Träger (1) eine erste und eine zweite von außen zugängliche Öffnung (12, 13) aufweist und daß die erste und die zweite Öffnung (12, 13) unterschiedliche Form haben.

6. Gehäuse (3) nach einem der vorherigen Ansprüche, dadurch gekennzeichnet, daß die Kontaktbahnen (35) im Innern des Gehäuses (3) direkt gegen einen auf ein elastisches Material (8) aufgebrachten Gegenkontakt (15) drücken, der gleichzeitig mit Kontakten mindestens einer Leiterplatte (5, 6) elektrisch leitend verbunden ist.

7. Gehäuse (3) nach einem der vorherigen Ansprüche, dadurch gekennzeichnet, daß die Kontaktbahnen (35) an dem Ende, das mit den Kontakten (14) versehen ist, aus dem ersten Träger (1) herausragen und in einem Spalt (40) des Gehäuses (3) vorzugsweise mittels Spritzguß wasser und gasdicht vom Gehäuse (3) umschlossen sind.

8. Gehäuse (3) nach einem der vorherigen Ansprüche, dadurch gekennzeichnet, daß die Kontakte (14) im ersten Träger (1) gegenüber den Kontaktbahnen (35) zum Gehäuseäußeren hin gebogen sind.

9. Gehäuse (3) nach einem der vorherigen Ansprüche, dadurch gekennzeichnet, daß der dritte Träger (100) zum Gehäuse (3) hin eine Wulst (45) aufweist, die in einer Nut (50) des Gehäuses (3) rastet.

10. Gehäuse (3) nach einem der vorherigen Ansprüche, dadurch gekennzeichnet, daß der erste Träger (1) an seiner dem Gehäuseäußeren zugewandten Seite Vorsprünge (55) aufweist, die in entsprechende Einbuchtungen (60) des Gehäuse (3) greifen.
